# FASCICULE DE BREVET EUROPEEN

(11) **EP 2 822 028 B1**
(45) Date de publication et mention de la délivrance du brevet: **04.11.2015**
(21) Numéro de dépôt: 14173405.3
(22) Date de dépôt: 23.06.2014
(51) Int. Cl.: H01L 21/324, H01L 33/00, H01L 21/225, H01L 21/265

(54) **Procédé d'activation électrique d'espèces dopantes dans un film de GaN**
Verfahren zur elektrischen Aktivierung von Dotierstoffen in einer GaN-Schicht
Method for electrical activation of dopant species in a GaN film

(30) Priorité: 03.07.2013 FR 1356481
(43) Date de publication de la demande: 07.01.2015
(73) Titulaire: COMMISSARIAT A L'ENERGIE ATOMIQUE ET AUX ENERGIES ALTERNATIVES, 75015 Paris (FR)
(72) Inventeur: Agraffeil, Claire, 38000 GRENOBLE (FR)
(74) Mandataire: Delorme, Nicolas

(56) Documents cités:
- NIIYAMA Y ET AL: "Si Ion implantation into Mg-doped GaN for fabrication of reduced surface field metal-oxide-semiconductor field-effect transistors", JAPANESE JOURNAL OF APPLIED PHYSICS PART.2, THE JAPAN SOCIETY OF APPLIED PHYSICS, JAPAN SOCIETY OF APPLIED PHYSICS, TOKYO; JP, vol. 47, no. 7, 1 juillet 2008 (2008-07-01), pages 5409-5416, XP001517730, ISSN: 0021-4922, DOI: 10.1143/JJAP.47.5409
- HAGER C ET AL: "Implant activation in GaN Using an AlN cap", SEMICONDUCTOR DEVICE RESEARCH SYMPOSIUM, 2007 INTERNATIONAL, IEEE, PISCATAWAY, NJ, USA, 12 décembre 2007 (2007-12-12), pages 1-2, XP031225721, ISBN: 978-1-4244-1891-6
- MATSUNAGA S ET AL: "Silicon implantation in epitaxial GaN layers: Encapsulant annealing and electrical properties", JOURNAL OF APPLIED PHYSICS, AMERICAN INSTITUTE OF PHYSICS, 2 HUNTINGTON QUADRANGLE, MELVILLE, NY 11747, vol. 95, no. 5, 1 mars 2004 (2004-03-01), pages 2461-2466, XP012067504, ISSN: 0021-8979, DOI: 10.1063/1.1644896
- ALURI GEETHA ET AL: "Microwave annealing of Mg-implanted and in situ Be-doped GaN", JOURNAL OF APPLIED PHYSICS, AMERICAN INSTITUTE OF PHYSICS, 2 HUNTINGTON QUADRANGLE, MELVILLE, NY 11747, vol. 108, no. 8, 19 octobre 2010 (2010-10-19), pages 83103-83103, XP012143222, ISSN: 0021-8979, DOI: 10.1063/1.3493266

## Description

La présente invention concerne un procédé d'activation électrique d'espèces dopantes dans un film de GaN.

Le GaN est un matériau semiconducteur présentant une grande bande interdite. Il est ainsi avantageusement utilisé dans le domaine de l'optoélectronique (LED) et des transistors à haute mobilité électronique (HEMT). La valeur de sa bande interdite (3,43eV à 300K), son champ critique élevé (3.3.10⁶V.cm⁻¹) et la grande mobilité de ses électrons (3.10⁷cm.s⁻¹) font du GaN un matériau au fort potentiel pour des applications dans la microélectronique de puissance. Cependant, quelques étapes clés de préparation du matériau, tel que le dopage par implantation, doivent encore être maitrisées. En effet, le GaN est un matériau qui est sensible aux traitements thermiques effectués à haute température, tels que ceux nécessaires à l'activation électrique des dopants implantés. Cette instabilité thermique est liée au fait notamment que des molécules d'azote s'évaporent du GaN et conduisent à la décomposition du matériau à partir de 850°C environ.

Le document Niiyama Y. et al: "Si Ion implantation into Mg-doped GaN for fabrication of reduced surface field metal-oxide-semiconductor field-effect transistors", JAPANESE JOURNAL OF APPLIED PHYSICS, PART 2, vol. 47, no. 7, 1 juillet 2008, pages 5409-5416, divulgue un procédé d'activation électrique d'espèces dopantes dans un film de GaN.

Or l'activation de dopants, tel que le Mg, Zn, Ca (dopants de type p) ou le Si, Ge, O (dopant de type n) nécessite d'appliquer un traitement thermique à des températures supérieures à 1000°C. Il a alors été proposé de déposer des couches de protection (cap-layer) en surface de la couche de GaN afin d'éviter l'évaporation d'azote. Ces couches de protection sont généralement constituées de SiO2, Si3N4 ou d'AIN et sont déposées par des techniques telles que le dépôt par PVD (Physical Vapor Deposition), PEVCD (Plasma Enhanced Vapor Chemical Deposition), par pulvérisation, par laser pulsé (PLD), ou par épitaxie notamment dans le cas de l'AIN, sur une épaisseur comprise entre plusieurs nanomètres et environ 1 micromètre. Mais ces couches de protection n'ont pas donné de résultats complètement satisfaisants. Au-delà d'une certaine température et/ou d'une certaine durée de traitement thermique, la couche écran se détériore ou délamine de la couche de GaN. Ceci provient principalement de la différence de paramètre de maille entre le GaN et le matériau déposé et du dégagement d'azote dû à la décomposition du GaN et à la mauvaise qualité des couches de protection déposées à basses températures (typiquement en dessous de 800°C). De plus, la surface du GaN obtenue est souvent fortement rugosifiée du fait de l'évaporation de l'azote. Afin de limiter l'apparition de tels inconvénients, la durée ou la température du traitement thermique d'activation est réduite de sorte que l'activation électrique des dopants est limitée.

Il existe alors un besoin de fournir un procédé permettant l'activation d'espèces dopantes dans le GaN qui pallie au moins un des inconvénients précités. A cet effet, la présente invention propose un procédé d'activation électrique d'espèces dopantes dans un film de GaN comprenant les étapes consistant à :
a) Fournir un empilement comprenant un substrat support et un film de GaN comprenant des espèces dopantes,
b) Coller par collage direct une couche écran présentant une épaisseur supérieure à 2 micromètres à la surface du film de GaN, de sorte à former une structure d'activation et
c) Appliquer un budget thermique à ladite structure d'activation selon des conditions permettant d'activer électriquement au moins une partie desdites espèces dopantes.

Par l'expression collage direct il est entendu dans le présent document, un collage direct sans interposition de matière adhésive, glue ou colle. Mais il est entendu dans le présent document que le 'collage direct', parfois désigné par l'expression 'collage par adhésion moléculaire' ou 'collage moléculaire' est généré par une mise en contact directe ou une mise en contact indirecte de la couche écran et du film de GaN. Il est en effet possible d'intercaler une ou plusieurs autres couches distinctes, telle qu'une couche de collage facilitant le collage entre la couche écran et le film de GaN.

Par « activer électriquement au moins une partie des espèces dopantes », on entend qu'au moins une partie des espèces dopantes se positionne en un site gallium du cristal GaN (site substitutionnel). Le taux d'espèces dopantes activées peut être très variable pour observer un effet significatif dans le matériau. Ainsi, il suffit que 1% à 20% des espèces implantées soient activées dans le cas d'une implantation de Mg (typiquement de l'ordre de 1% à 5%). Pour un dopant de silicium, il faudra activer au moins 90% du silicium implanté. Si le dopage est réalisé durant l'épitaxie du film de GaN (et pas un dopage obtenu par implantation ultérieure), 100% des espèces dopantes peuvent être activées.

Ainsi, grâce au procédé de l'invention, il est possible d'appliquer un budget thermique adapté à l'activation des espèces ioniques tout en limitant la détérioration de la couche de GaN. En effet, le collage direct apporte une tenue mécanique de liaison renforcée entre la couche écran et le film de GaN par comparaison à la tenue mécanique de la liaison obtenue par dépôt d'une couche sur le film de GaN. Grâce à la présente invention, les conditions pour provoquer la délamination de la couche écran sont plus drastiques à atteindre. Il est ainsi possible d'augmenter le budget thermique d'activation sans risquer la délamination, par comparaison avec le budget thermique d'activation applicable avec une couche déposée.

De plus, le collage direct d'une couche écran permet de choisir une épaisseur importante de couche, ce qui n'est pas le cas lors du dépôt de couche, du fait notamment de la différence de paramètre de maille. Or, il a été constaté que pour une épaisseur de couche écran suffisamment importante et de bonne qualité cristalline, les risques de délamination sont significativement réduits. Or de telles épaisseurs (typiquement supérieures à 2 voire 5 ou 10 micromètres) sont difficilement accessibles par dépôt et ce avec une qualité cristalline satisfaisante. Le dépôt doit en effet être réalisé à une température compatible avec la présence du GaN (typiquement autour de 800°C), ce qui ne permet pas d'obtenir des couches de bonne qualité cristalline.

Selon une disposition, l'étape c) d'application du budget thermique comprend l'application d'au moins un traitement thermique à une température supérieure à 1000°C, voire supérieure à 1200°C pendant une durée comprise entre plusieurs minutes et plusieurs jours. Il est notamment possible d'aller au-delà de ces températures, par exemple jusqu'à 1300°C voire 1350°C avec un substrat support de silicium et jusqu'à 1600°C avec un substrat support de saphir avec une durée de traitement thermique très courte dans ce cas.

Il est entendu que les conditions d'application du budget thermique dépendent de la nature des espèces dopantes à activer, de leur concentration dans le film de GaN et des propriétés électrique attendues du GaN dopé. Dans le cas d'espèces dopantes de silicium par exemple, la durée du traitement thermique d'activation peut être de 5 min à 1250°C. On active ainsi plus de 90% des dopants. Dans le cas d'espèces dopantes de magnésium, le traitement thermique peut être de 48 heures à 1250°C pour permettre l'activation typiquement de 5% des dopants.

Selon une variante, l'étape c) d'application du budget thermique comprend l'application de plusieurs séquences de traitements thermiques, chaque séquence étant réalisée à une température identique ou variable et sur une durée identique ou variable. La demanderesse a en effet pu observer que le fait de multiplier les séquences permettait d'augmenter le budget thermique total appliqué. Quatre cycles de 4h à 1100°C ont ainsi pu être effectués sans détérioration du GaN.

De préférence, le procédé comprend avant l'étape a) une étape i) consistant à réaliser une épitaxie du film de GaN sur le substrat support. Ceci permet l'obtention de GaN cristallin, voire monocristallin, avec peu de défauts. Cette qualité cristalline permet par la suite d'optimiser les performances des dispositifs et composants électroniques formés à partir de ce film.

Selon une possibilité, le dopage est réalisé pendant l'étape i) d'épitaxie.

Typiquement, le procédé comprend avant l'étape a) une étape k) consistant à diffuser des espèces dopantes dans le film de GaN.

Selon une autre possibilité, le procédé comprend avant l'étape a) une étape j) consistant à implanter des espèces dopantes dans le film de GaN. Ceci permet d'obtenir un dopage localisé favorable à la fabrication ultérieure de dispositifs. Cela permet également (contrairement au dopage pendant l'épitaxie) de réaliser facilement des zones de dopage de types opposés (n et p) à des endroits localisés en fonction du dispositif à réaliser à cet endroit. On peut pour ce faire implanter par exemple à travers des masques différents. Les espèces (n et p) pourront ensuite être activées simultanément.

Les espèces dopantes peuvent être de type n ou de type p telles que respectivement du silicium pour le dopage n ou pour le dopage p du magnésium, Ca, Be ou une co-implantation de Mg avec P, Ca, O ou N. L'implantation peut être réalisée par tout implanteur industriel fonctionnant à température ambiante, à basse (typiquement autour de -15°C) ou haute température (jusqu'à 500°C) selon la nature des dopants. Les paramètres de l'implantation, tels que l'énergie et la dose implantée sont définis par les propriétés électriques finales souhaitées. L'énergie est fonction de la profondeur d'implantation recherchée. Typiquement pour une implantation de Mg ou de Si, l'énergie pourra être de l'ordre de 200 KeV pour obtenir une profondeur d'implantation de l'ordre de 400nm. La dose pourra être autour de 2^{e}15 at/cm² pour Mg ou Si pour obtenir une signature électrique n ou p satisfaisante pour la réalisation de dispositifs.

Selon une variante, l'étape j) d'implantation comprend une implantation à la fois de dopants de type n et de dopants de type p.

De préférence, le matériau du substrat support présente un coefficient de dilatation thermique similaire à celui du matériau de la couche écran de sorte que la structure puisse subir le recuit d'activation à haute température (typiquement autour de 1200°C voire au-delà) sans risque de casse.

Avantageusement, le matériau du substrat support est identique à celui de la couche écran. Ce mode de réalisation permet de limiter l'apparition de contraintes par différences de dilatation ou de contraction au cours des variations de températures exercées sur la structure d'activation. Ainsi, les risques de fragilisation de la couche écran sont limités. L'adhérence de la couche écran n'est pas affaiblie de sorte que le risque de délamination de la couche écran est réduit.

Selon une disposition particulière, le substrat support est constitué de saphir et la couche écran est constituée de saphir ou d'alumine. Dans ce cas, le traitement thermique d'activation des dopants est avantageusement réalisé entre 1400 et 1600°C.

Selon une autre disposition le substrat support est constitué de silicium et la couche écran est constituée de silicium ou de verre (si ce dernier comporte un CTE adapté avec le budget thermique à appliquer). Dans ce cas, le traitement thermique d'activation des dopants peut être réalisé entre 1000°C et 1350°C et avantageusement entre 1000°C et 1250°C.

De préférence, la couche écran est constituée d'un matériau cristallin. Le matériau cristallin ayant une meilleure résistance thermique qu'un matériau non cristallin, le risque d'endommagement de la couche écran est alors limité au cours de l'application du budget thermique.

Selon une possibilité, le procédé comprend avant l'étape c) une étape consistant à déposer une couche de collage sur le film de GaN et/ou sur la couche écran, la couche de collage comprenant au moins un matériau choisi parmi le SiO2, Si3N4, AIN, Al2O3, et le Si amorphe.

Cette couche de collage interposée entre la couche écran et la surface du film de GaN permet de faciliter le collage direct et l'obtention d'une forte énergie de collage. Il est entendu que l'expression 'couche de collage' ne signifie pas une couche d'un matériau constitué de colle ou autre matière adhésive mais une couche facilitant le collage direct.

Avantageusement, la couche de collage comprend une couche d'AIN et une couche de SiO2. Dans ce cas, la couche d'AIN sert avantageusement de barrière à la diffusion d'éléments contaminants. En effet, aux températures du budget thermique appliqué à l'étape c) des éléments contenus dans la couche écran, par exemple en silicium, peuvent diffuser jusqu'au film de GaN. Ces éléments peuvent contaminer le GaN et altérer ses propriétés électriques surtout en cas de dopage p, le silicium de la couche écran ayant diffusé (dopant n) venant « compenser » le dopage p de la couche de GaN.

Selon une possibilité, le procédé comprend avant l'étape b) de collage, une étape k) consistant à implanter des espèces ioniques dans un substrat source de sorte à créer un plan de fragilisation délimitant de part et d'autre, la couche écran et un négatif du substrat source. Cette étape k) permet de facilement transférer une couche écran d'une épaisseur supérieure à 2 micromètres sur le film de GaN. De plus, il est possible de recycler le négatif du substrat source, ce qui permet de faire des économies notamment lorsque des substrats source cristallins sont utilisés. Il est entendu que l'implantation des espèces ioniques de fragilisation du substrat source à l'étape k) est réalisée à travers la couche écran qui est ensuite collée sur le film de GaN pour former la structure d'activation.

Selon une possibilité, le procédé comprend avant l'étape b) de collage, une étape m) consistant à déposer une couche de recouvrement sur la couche écran, la couche de recouvrement comprenant au moins un matériau choisi parmi le SiO2, Si3N4, AlN, Al2O3, et le Si amorphe.

Cette couche de recouvrement permet avantageusement d'augmenter l'épaisseur de la couche écran, par exemple avec un matériau peu coûteux, de sorte à augmenter encore sa rigidité. Cette couche de recouvrement a typiquement une épaisseur maximale comprise entre 5 et 10 µm. Par rapport à un dépôt effectué directement sur le film de GaN, le dépôt de la couche de recouvrement est facilité (notamment si la couche écran est en silicium), on obtient ainsi une couche déposée de meilleure qualité cristalline permettant d'envisager des budgets thermiques ultérieurs plus importants.

Avantageusement, l'étape m) de dépôt d'une couche de recouvrement est réalisée entre les étapes k) d'implantation et b) de collage. Il est ainsi possible d'obtenir le transfert d'une couche écran épaissie par la couche de recouvrement et présentant une épaisseur supérieure à 2 micromètres, par exemple de 5 à 10 micromètres, sans nécessiter d'utiliser des conditions pour une implantation très profonde qui peuvent être très couteuses.

Selon une autre possibilité, la couche de recouvrement est collée au film de GaN ou la couche de recouvrement est déposée sur la face opposée à la face de la couche écran collée au film de GaN. La couche écran résultante présente ainsi une efficacité (en termes de barrière et de protection notamment) et une rigidité améliorées.

Selon une variante, la couche de recouvrement peut également être répartie de part et d'autre de l'interface de collage entre la couche écran et le film de GaN avant collage. Toutes les variantes précitées concernant la couche de recouvrement pouvant être combinées.

De préférence, le procédé comprend après l'étape k) d'implantation et l'étape b) de collage, une étape n) consistant à appliquer un traitement thermique de fracture permettant de fracturer le substrat source au niveau du plan de fragilisation.

Selon une possibilité, l'étape n) d'application du traitement thermique de fracture est réalisée de façon concomitante à l'étape c) d'application du budget thermique. Ainsi, les traitements thermiques de fracture et d'activation peuvent être réalisés dans le même four en appliquant une rampe de température adaptée.

Selon une alternative, la couche écran est une couche autoportée, et de préférence la couche écran est un substrat massif. Par le terme 'couche autoportée', on entend une couche qui présente une épaisseur telle que sa tenue mécanique lui permet d'être manipulée, notamment sans s'enrouler sur elle-même. Cette épaisseur dépend de la nature du matériau. Généralement une couche autoportée présente une épaisseur supérieure à 15 micromètres et avantageusement supérieure à 50 micromètres.

Par l'expression 'substrat massif', on entend un substrat comportant un seul matériau et présentant une épaisseur supérieure à 50 micromètres, typiquement de l'ordre de 750µm comme la plupart des substrats disponibles dans le commerce. L'utilisation d'un substrat massif dans le procédé de l'invention permet de tirer parti de substrats disponibles dans le commerce, peu couteux, et qui ne nécessitent pas de préparation très importante avant emploi.

Ainsi, selon le procédé d'obtention de la couche écran, il est possible de choisir une épaisseur supérieure à 2 micromètres, à 10 micromètres, à 20 ou 100 micromètres et voire davantage. Ceci permet d'adapter l'épaisseur de la couche écran au budget thermique d'activation des espèces dopantes.

Selon une disposition complémentaire, le procédé comprend après l'étape c) d'application du budget thermique, une étape d) consistant à retirer la couche écran de sorte à exposer la face supérieure du film de GaN dopé. Ce procédé permet ainsi d'obtenir un film de GaN dopé prêt à être utilisé, notamment pour des applications en microélectronique de puissance et en optoélectronique.

Avantageusement, le procédé comprend après l'étape d) une étape e) consistant à fabriquer des dispositifs à partir du film de GaN dopé pour des applications dans le domaine optoélectronique ou des dispositifs de puissance.

D'autres aspects, buts et avantages de la présente invention apparaîtront mieux à la lecture de la description suivante de deux modes de réalisation de celle-ci, donnée à titre d'exemples non limitatifs et faite en référence aux dessins annexés. Les figures ne respectent pas nécessairement l'échelle de tous les éléments représentés de sorte à améliorer leur lisibilité. Des traits pointillés sont utilisés sur les figures de sorte à illustrer un plan de fragilisation. Dans la suite de la description, par souci de simplification, des éléments identiques, similaires ou équivalents des différentes formes de réalisation portent les mêmes références numériques.
Les figures 1 à 7 illustrent des étapes d'un procédé d'activation d'espèces dopantes selon un premier mode de réalisation de l'invention.
Les figures 8 à 14 illustrent des étapes d'un procédé d'activation d'espèces dopantes selon un second mode de réalisation de l'invention.

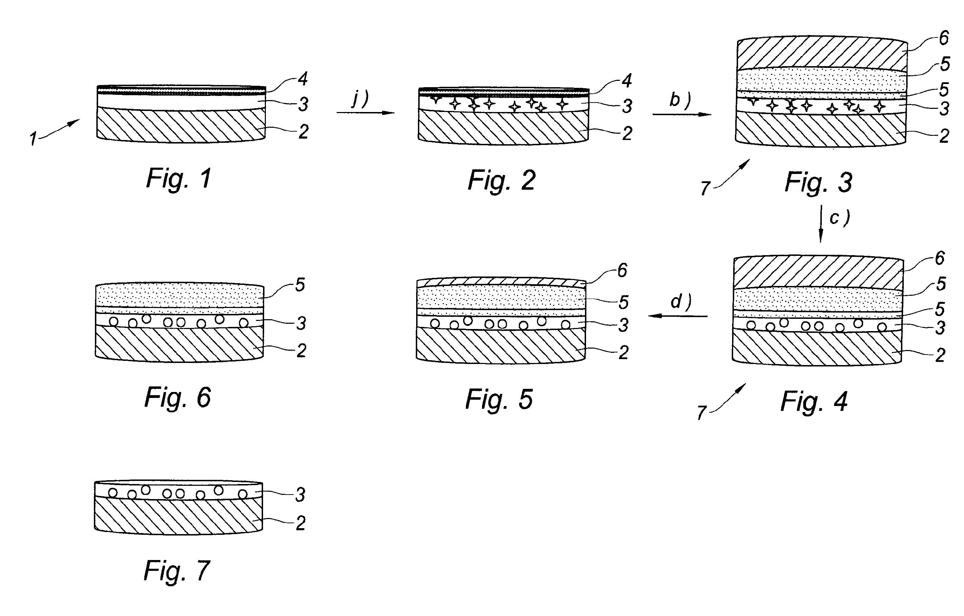

La figure 1 illustre la première étape du procédé consistant à fournir un empilement 1 comprenant un substrat support 2 et un film 3 de GaN (étape a). Le substrat support 2 est un substrat massif constitué de saphir et sur lequel un film 3 de GaN monocristallin a été déposé par épitaxie sur une épaisseur d'environ 1 micromètre (étape i). Il est possible de prévoir avant l'épitaxie de GaN, l'épitaxie d'une couche tampon (généralement appelée buffer layer) par exemple en AlGaN (par exemple de 1 µm d'épaisseur) pour faciliter la gestion de la différence de paramètre de maille et ainsi augmenter la tension de claquage des dispositifs formés ultérieurement. Puis, avant de procéder à l'étape d'implantation d'espèces dopantes, une étape optionnelle de préparation de surface est tout d'abord effectuée, telle qu'une étape de nettoyage avec une solution NH4OH /H2O à 60°C ou avec une solution diluée de HF, ou une étape de désoxydation de la surface de GaN. Une couche de protection 4 est ensuite déposée en surface du film 3 de GaN en vue limiter l'apparition de défauts cristallins générés par l'implantation des dopants et surtout de limiter les effets de canalisation pendant l'implantation ionique en favorisant une distribution aléatoire des dopants. Cette couche de protection 4 est typiquement constituée par de l'oxyde de silicium, du nitrure de silicium, de l'AIN, de l'alumine ou du silicium amorphe.

La figure 2 illustre une étape consistant à implanter des espèces dopantes telles que du Mg avec une dose de 2.10¹⁵ at/cm⁻² dans le film 3 de GaN (étape j).Cette implantation peut être réalisée dans tout type d'implanteur et notamment un implanteur industriel de type NV8200.

Bien entendu, les conditions de l'implantation varient selon les propriétés électriques finales du GaN attendues.

Une étape de nettoyage et éventuellement de CMP (polissage mécano-chimique) de la surface est de préférence effectuée avant de déposer une couche de collage 5, telle qu'une couche de SiO2 ou de nitrure de silicium. Il est également procédé à un traitement plasma optionnel pour activer la surface exposée et favoriser le collage.

Comme illustré à la figure 3, un substrat de saphir est mis en contact avec le film 3 de GaN pour un collage direct par l'intermédiaire d'une couche de collage 5 déposée sur le film 3 comme sur le substrat de saphir. Le substrat de saphir étant cristallin et épais, il forme une couche écran 6 efficace pour la protection du film 3 de GaN pendant l'application du budget thermique d'activation. Une fois le collage direct réalisé, on obtient ainsi une structure d'activation 7 apte à supporter un traitement thermique d'activation électrique des espèces dopantes de Mg (étape c).

Il est à noter que le substrat de saphir a pu subir une préparation préalable, telle qu'un nettoyage comprenant typiquement un traitement de type RCA et un traitement d'activation plasma de sa surface avant l'étape b) de collage.

Ainsi, le coefficient de dilatation thermique du substrat support 2 est identique à celui de la couche écran 6 constituée du même matériau. Les risques d'endommagement de la structure d'activation 7 par délamination ou de création de défauts dans les matériaux des différentes couches par différence de dilatation au cours des changements de températures appliqués sont ainsi réduits.

La figure 4 illustre l'étape c) du procédé consistant à appliquer un budget thermique à la structure d'activation 7 à environ 1400°C pendant 30 minutes de sorte à activer électriquement environ 1 à 10% du magnésium implanté.

La surface du film 3 de GaN dopé p est ensuite libérée de la couche écran 6 de saphir, en vue de la fabrication de dispositifs (étape d). Le substrat de saphir 6 est alors éliminé en partie par une étape de rectification, notamment jusqu'à atteindre une épaisseur d'environ 20 micromètres (figure 5). Ensuite une gravure humide sélective du saphir restant est effectuée, par exemple en utilisant du TMAH (TetraMethylAmmonium Hydroxide) qui permet de stopper la gravure à la couche de collage 5 de SiO2. Puis une gravure humide avec une solution diluée de HF est effectuée de sorte à retirer la totalité de la couche de collage 5 de SiO2 et exposer la surface du film 3 de GaN dopé p (figure 7). D'autres techniques sont possibles, notamment par lift off, insertion de lame ou laser lift off.

Selon une variante non illustrée, la couche de collage 5 déposée sur le film 3 de GaN avant mise en contact avec la couche écran 6, comprend une couche barrière de diffusion par exemple d'AIN pour éviter la diffusion éventuelles d'espèces contaminantes.

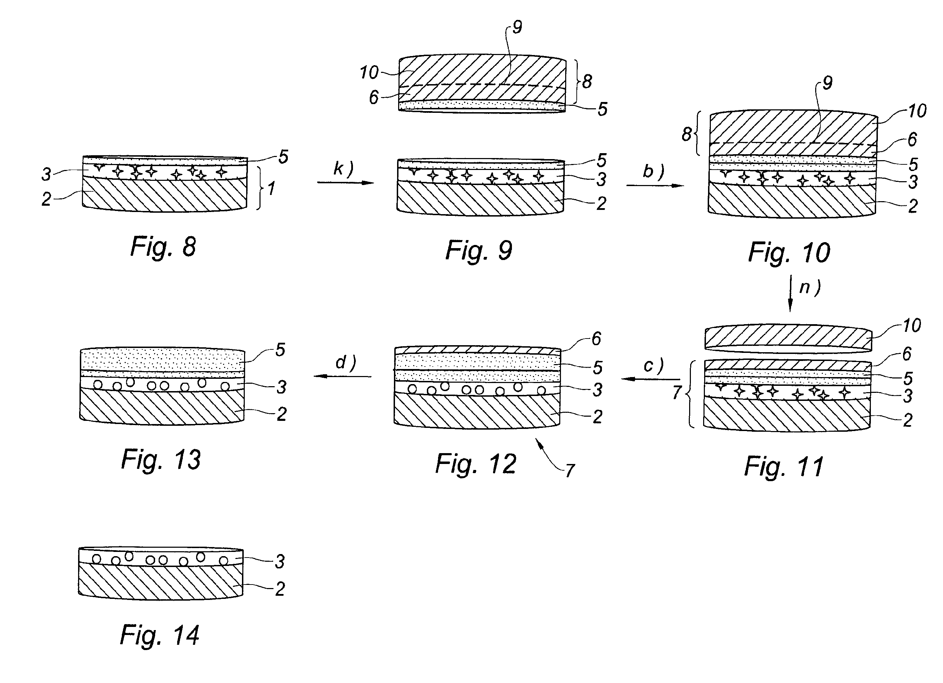

Les figures 8 à 14 illustrent un deuxième mode de réalisation du procédé d'application du traitement thermique. La figure 8 représente un empilement 1 constitué d'un substrat support 2 de silicium et d'un film 3 de GaN dans lequel ont été implantées des espèces dopantes de silicium. Une couche de collage 5 de SiO2 a été déposée en surface du film 3 en vue du collage avec une couche écran 6.

La figure 9 illustre une étape k) d'implantation d'espèces ioniques, telle que l'hydrogène avec une énergie de 200KeV et une dose comprise entre10¹⁶ et 10¹⁷ at/cm², dans un substrat source 8 de silicium afin de former un plan de fragilisation 9 délimitant une couche écran 6 d'environ 2 micromètres et un négatif 10 du substrat source 8. Comme il est d'usage, différentes étapes de préparation de surface ainsi qu'une couche de protection 4 ont été effectuées avant de procéder à l'implantation. Il est entendu que les espèces ioniques implantées ont traversé la couche écran 6 pour venir former le plan de fragilisation 9 à une profondeur du substrat source 8 déterminée entre autre par l'énergie d'implantation.

Une couche de collage 5, par exemple en SiO2 est déposée sur le substrat source 8 fragilisé avant de réaliser l'étape b) de collage direct avec le film 3 de GaN (figure 10).

Puis un traitement thermique de fracture est réalisé à une température comprise entre 400°C et 500°C, de sorte à détacher le négatif 10 de la couche écran 6 (figure 11- étape n).

La structure d'activation 7 obtenue est alors soumise au budget thermique d'activation électrique du dopant en Si à 1200°C pendant au moins 30 minutes (figure 12- étape c). Une activation électrique de 70% voire 100% des espèces dopantes est ainsi obtenue.

Enfin, la couche écran 6 de silicium est éliminée en partie par une étape de rectification, notamment jusqu'à atteindre une épaisseur d'environ 20 micromètres. Ensuite une gravure humide sélective du silicium restant est effectuée, par exemple en utilisant du TMAH (TetraMethylAmmonium Hydroxide) qui permet de stopper la gravure à la couche de collage 5 de SiO2 (figure 13- étape d). Puis une gravure humide avec une solution diluée de HF est effectuée de sorte à retirer la totalité de la couche de collage 5 résiduelle de SiO2 et exposer le film 3 de GaN dopé n (figure 14).

Selon une variante de réalisation non illustrée, une couche de recouvrement est déposée sur la couche écran 6 avant l'étape b) de collage de sorte à augmenter l'épaisseur et la rigidité de la couche écran 6.

Ainsi, la présente invention apporte une amélioration déterminante à l'état de la technique antérieure en proposant un procédé d'activation électrique d'espèces dopantes dans un film 3 de GaN qui est efficace et limite l'endommagement de la surface du film 3 de GaN obtenu. Ce film 3 est ensuite avantageusement utilisé dans la fabrication de dispositifs optoélectroniques ou de puissance aux performances améliorées.

Il va de soi que l'invention n'est pas limitée aux modes de réalisation décrits ci-dessus à titre d'exemples mais qu'elle comprend tous les équivalents techniques et les variantes des moyens décrits ainsi que leurs combinaisons.

## Revendications

1. Procédé d'activation électrique d'espèces dopantes dans un film (3) de GaN **caractérisé en ce que** le procédé comprend les étapes consistant à :
a) Fournir un empilement (1) comprenant un substrat support (2) et un film (3) de GaN comprenant des espèces dopantes,
b) Coller par collage direct une couche écran (6) présentant une épaisseur supérieure à 2 micromètres à la surface du film (3) de GaN, de sorte à former une structure d'activation (7), et
c) Appliquer un budget thermique à ladite structure d'activation (7) selon des conditions permettant d'activer électriquement au moins une partie desdites espèces dopantes.

2. Procédé selon la revendication 1, **caractérisé en ce que** l'étape c) d'application du budget thermique comprend l'application d'au moins un traitement thermique à une température supérieure à 1000°C, voire supérieure à 1200°C, pendant une durée comprise entre plusieurs minutes et plusieurs jours.

3. Procédé selon l'une des revendications 1 à 2, **caractérisé en ce que** l'étape c) d'application du budget thermique comprend l'application de plusieurs séquences de traitements thermiques, chaque séquence étant réalisée à une température identique ou variable et sur une durée identique ou variable.

4. Procédé selon l'une des revendications 1 à 3, **caractérisé en ce que** le procédé comprend avant l'étape a) une étape i) consistant à réaliser une épitaxie du film (3) de GaN sur le substrat support(2).

5. Procédé selon la revendication 4, **caractérisé en ce que** le film (3) de GaN est dopé pendant l'étape i) d'épitaxie.

6. Procédé selon l'une des revendications 1 à 4, **caractérisé en ce que** le procédé comprend avant l'étape a) une étape j) consistant à implanter des espèces dopantes dans le film (3) de GaN.

7. Procédé selon la revendication 6, **caractérisé en ce que** l'étape j) d'implantation comprend une implantation à la fois de dopants de type n et de dopants de type p.

8. Procédé selon l'une des revendications 1 à 7, **caractérisé en ce que** le substrat support (2) est constitué de saphir et la couche écran (6) est constituée de saphir ou d'alumine, ou **en ce que** le substrat support (2) est constitué de silicium et la couche écran (6) est constituée de silicium ou de verre.

9. Procédé selon l'une des revendications 1 à 8, **caractérisé en ce que** la couche écran (6) est constituée d'un matériau cristallin.

10. Procédé selon l'une des revendications 1 à 9, **caractérisé en ce que** le procédé comprend avant l'étape b) de collage, une étape k) consistant à implanter des espèces ioniques dans un substrat source (8) de sorte à créer un plan de fragilisation (9) délimitant de part et d'autre la couche écran (6) et un négatif (10) du substrat source (8).

11. Procédé selon l'une des revendications 1 à 10, **caractérisé en ce que** le procédé comprend avant l'étape b) de collage une étape m) consistant à déposer une couche de recouvrement sur la couche écran (6), la couche de recouvrement comprenant au moins un matériau choisi parmi le SiO2, Si3N4, AlN, Al2O3, et le Si amorphe.

12. Procédé selon l'une des revendications 10 à 11, **caractérisé en ce que** le procédé comprend après l'étape b) de collage une étape n) consistant à appliquer un traitement thermique de fracture permettant de fracturer le substrat source (8) au niveau du plan de fragilisation (9) et **en ce que** le traitement thermique de fracture est réalisé de façon concomitante à l'étape c) d'application du budget thermique.

13. Procédé selon l'une des revendications 1 à 12, **caractérisé en ce que** le procédé comprend après l'étape c) d'application du budget thermique, une étape d) consistant à retirer la couche écran (6) de sorte à exposer la face supérieure du film (3) de GaN dopé puis une étape e) consistant à fabriquer des dispositifs à partir du film (3) de GaN dopé pour des applications dans le domaine optoélectronique ou des dispositifs de puissance.

## Patentansprüche

1. Verfahren zur elektrischen Aktivierung von Dotiermittelspezies in einem GaN-Film (3), **dadurch gekennzeichnet, dass** das Verfahren die in Folgendem bestehenden Schritte umfasst:
a) Bereitstellen eines Stapels (1), der ein Trägersubstrat (2) und einen GaN-Film (3), der Dotiermittelspezies umfasst, umfasst,
b) Bonden einer Abschirmschicht (6), die eine Dicke von mehr als 2 Mikrometer aufweist, mit der Oberfläche des GaN-Films (3) durch direktes Bonding, um eine Aktivierungsstruktur (7) zu bilden, und
c) Anwenden eines thermischen Budgets auf die besagte Aktivierungsstruktur (7) gemäß Bedingungen, die das elektrische Aktivieren mindestens eines Teils der besagten Dotiermittelspezies ermöglichen.

2. Verfahren nach Anspruch 1, **dadurch gekennzeichnet, dass** der Schritt c) der Anwendung des thermischen Budgets die Anwendung mindestens einer Wärmebehandlung bei einer Temperatur von mehr als 1000 °C, sogar mehr als 1200 °C für einen Zeitraum, der zwischen mehreren Minuten und mehreren Tagen umfasst, umfasst.

3. Verfahren nach einem der Ansprüche 1 bis 2, **dadurch gekennzeichnet, dass** der Schritt c) der Anwendung des thermischen Budgets die Anwendung mehrerer Sequenzen von Wärmebehandlungen umfasst, wobei jede Sequenz bei einer identischen oder variablen Temperatur und mit einem identischen oder variablen Zeitraum durchgeführt wird.

4. Verfahren nach einem der Ansprüche 1 bis 3, **dadurch gekennzeichnet, dass** das Verfahren vor dem Schritt a) einen Schritt i) umfasst, der in dem Durchführen einer Epitaxie des GaN-Films (3) auf dem Trägersubstrat (2) besteht.

5. Verfahren nach Anspruch 4, **dadurch gekennzeichnet, dass** der GaN-Film (3) während des Epitaxieschritts i) dotiert wird.

6. Verfahren nach einem der Ansprüche 1 bis 4, **dadurch gekennzeichnet, dass** das Verfahren vor dem Schritt a) einen Schritt j) umfasst, der in dem Implantieren von Dotiermittelspezies in den GaN-Film (3) besteht.

7. Verfahren nach Anspruch 6, **dadurch gekennzeichnet, dass** der Implantationsschritt j) eine Implantation von sowohl Dotiermitteln des n-Typs als auch Dotiermitteln des p-Typs umfasst.

8. Verfahren nach einem der Ansprüche 1 bis 7, **dadurch gekennzeichnet, dass** das Trägersubstrat (2) aus Saphir besteht und die Abschirmschicht (6) aus Saphir oder Aluminiumoxid besteht oder dass das Trägersubstrat (2) aus Silicium besteht und die Abschirmschicht (6) aus Silicium oder Glas besteht.

9. Verfahren nach einem der Ansprüche 1 bis 8, **dadurch gekennzeichnet, dass** die Abschirmschicht (6) aus einem kristallinen Material besteht.

10. Verfahren nach einem der Ansprüche 1 bis 9, **dadurch gekennzeichnet, dass** das Verfahren vor dem Bondingschritt b) einen Schritt k) umfasst, der in dem Implantieren von ionischen Spezies in ein Source-Substrat (8) besteht, um eine Versprödungsebene (9) zu erzeugen, die zu beiden Seiten die Abschirmschicht (6) und ein Negativ (10) des Source-Substrats (8) abgrenzt.

11. Verfahren nach einem der Ansprüche 1 bis 10, **dadurch gekennzeichnet, dass** das Verfahren vor dem Bondingschritt b) einen Schritt m) umfasst, der in dem Abscheiden einer Abdeckschicht auf der Abschirmschicht (6) besteht, wobei die Abdeckschicht mindestens ein Material umfasst, das aus SiO2, Si3N4, AIN, Al2O3 und amorphem Si ausgewählt ist.

12. Verfahren nach einem der Ansprüche 10 bis 11, **dadurch gekennzeichnet, dass** das Verfahren nach dem Bondingschritt b) einen Schritt n) umfasst, der in dem Anwenden einer Bruch-Wärmebehandlung besteht, die das Brechen des Source-Substrats (8) auf Höhe der Versprödungsebene (9) ermöglicht, und dass die Bruch-Wärmebehandlung gleichzeitig mit dem Schritt c) der Anwendung des thermischen Budgets durchgeführt wird.

13. Verfahren nach einem der Ansprüche 1 bis 12, **dadurch gekennzeichnet, dass** das Verfahren nach dem Schritt c) der Anwendung des thermischen Budgets einen Schritt d), der in dem Herausziehen der Abschirmschicht (6) besteht, um die obere Fläche des dotierten GaN-Films (3) freizulegen, und dann einen Schritt e) umfasst, der in dem Herstellen von Bauelementen aus dem dotierten GaN-Film (3) für Anwendungen im optoelektronischen Bereich oder von Leistungsbauelementen besteht.

## Claims

1. A method for electrically activating dopant species in a GaN film (3) **characterized in that** the method comprises the steps consisting of :
a) Providing a stack (1) comprising a support substrate (2) and a GaN film (3) comprising dopant species,
b) Bonding, by direct bonding, a shield layer (6) exhibiting a thickness larger than 2 micrometers at the surface of the GaN film (3), so as to form an activation structure (7), and
c) Applying a thermal budget to said activation structure (7) under conditions which enable the electrical activation of at least one portion of said dopant species.

2. The method according to claim 1, **characterized in that** the thermal budget application step c) comprises the application of at least one heat treatment at a temperature higher than 1000°C, even higher than 1200°C, for a time duration comprised between several minutes and several days.

3. The method according to any of claims 1 to 2, **characterized in that** the thermal budget application step c) comprises the application of several heat treatment sequences, each sequence being carried out at an identical or variable temperature and over an identical or variable time duration.

4. The method according to any of claims 1 to 3, **characterized in that**, prior to step a), the method comprises a step i) consisting of carrying out an epitaxy of the GaN film (3) on the support substrate (2).

5. The method according to claim 4, **characterized in that** the GaN film (3) is doped during the epitaxy step i).

6. The method according to any of claims 1 to 4, **characterized in that**, prior to step a), the method comprises a step j) consisting of implanting dopant species in the GaN film (3).

7. The method according to claim 6, **characterized in that** the implantation step j) comprises an implantation of both n-type dopants and p-type dopants.

8. The method according to any of claims 1 to 7, **characterized in that** the support substrate (2) is constituted by sapphire and the shield layer (6) is constituted by sapphire or alumina, or **in that** the support substrate (2) is constituted by silicon and the shield layer (6) is constituted by silicon or glass.

9. The method according to any of claims 1 to 8, **characterized in that** the shield layer (6) is constituted by a crystalline material.

10. The method according to any of claims 1 to 9, **characterized in that**, prior to the bonding step b), the method comprises a step k) consisting of implanting ionic species in a source substrate (8) so as to create an embrittlement plane (9) delimiting either side of the shield layer (6) and a negative (10) of the source substrate (8).

11. The method according to any of claims 1 to 10, **characterized in that**, prior to the bonding step b), the method comprises a step m) consisting of depositing a covering layer on the shield layer (6), the covering layer comprising at least one material selected from SiO2, Si3N4, AIN, Al2O3, and amorphous Si.

12. The method according to any of claims 10 to 11, **characterized in that**, subsequently to the bonding step b), the method comprises a step n) consisting of applying a fracturing heat treatment which enables fracturing the source substrate (8) at the embrittlement plane (9) and **in that** the fracturing heat treatment is carried out concomitantly with the thermal budget application step c).

13. The method according to any of claims 1 to 12, **characterized in that** subsequently to the thermal budget application step c), the method comprises a step d) consisting of removing the shield layer (6) so as to expose the upper face of the doped GaN film (3) then a step e) consisting of manufacturing devices from the doped GaN film (3) for applications in the optoelectronics field or power devices.
